## Europäisches Patentamt

## European Patent Office

## Office européen des brevets

(19)

(11) Publication number : **0 348 895 B1**

## EUROPEAN PATENT SPECIFICATION

(12)

(45) Date of publication of patent specification :
17.05.95 Bulletin 95/20

(51) Int. Cl.$^6$ : **G11C 5/00, G11C 17/00**

(21) Application number : **89111678.2**

(22) Date of filing : **27.06.89**

(54) Semiconductor memory device provided with low-noise power supply structure.

(30) Priority : **27.06.88 JP 158733/88**
**27.06.88 JP 158741/88**

(43) Date of publication of application :
**03.01.90 Bulletin 90/01**

(45) Publication of the grant of the patent :
**17.05.95 Bulletin 95/20**

(84) Designated Contracting States :
**DE FR GB**

(56) References cited :
**EP-A- 0 081 368**
**EP-A- 0 151 870**
**EP-A- 0 255 125**
**GB-A- 2 087 183**
**ELECTRICAL DESIGN NEWS, vol. 18, no. 16,**
**20th August 1973, pages 50-60, Denver,US; M.**
**HOFF: "Designing with RAMs - Part II-**
**Conclusion"**

(73) Proprietor : **NEC CORPORATION**
**7-1, Shiba 5-chome**
**Minato-ku**
**Tokyo (JP)**

(72) Inventor : **Kobatake, Hiroyuki**
**c/o NEC Corporation**
**33-1, Shiba 5-chome**
**Minato-ku**
**Tokyo (JP)**

(74) Representative : **Glawe, Delfs, Moll & Partner**
**Patentanwälte**
**Postfach 26 01 62**
**D-80058 München (DE)**

## Description

## BACKGROUND OF THE INVENTION

Field of the Invention:

The present invention relates to a semiconductor memory device and, more particularly to a semiconductor read-only memory (ROM) fabricated on a semiconductor substrate.

Description of the Related Art:

A semiconductor memory device such as a ROM is constructed with a memory cell array of memory cells arranged in a matrix form of rows and columns, and peripheral circuit blocks such as a row selection circuit block for operatively selecting one of the rows of the memory cell array, a column selection circuit block for selecting the columns of the memory cell array, a sense amplifier circuit block for amplifying a signal or signals read out from the memory cell array and an output buffer section for outputting a read-out signal. Each of the circuit blocks are supplied with a power voltage (Vcc) and a reference voltage (Vss) such as a ground voltage (GND) by a power voltage wiring and a reference voltage wiring connected thereto, respectively.

The power voltage wiring and the reference voltage wiring are connected to external terminals through bonding pads and bonding wires, in a known way. Therefore, predetermined values of stray impedances are present between the bonding pads and the sources of the power voltage and the reference voltage. This means that potentials at the power voltage wiring and the reference voltage wiring are affected by current amount flowing into the circuit blocks. While, some of the circuit blocks such as the output buffer block or the row selection circuit block causes a large peak current flowing therethrough when the state thereof is changed. Such peak current flowing into the certain circuit block causes a potential change at the power voltage wiring or the reference voltage wiring and therefore the value of the power voltage or the reference voltage actually supplied to the circuit blocks is affected, resulting in erroneous operation of the circuit block or blocks.

EP-A-0081368 describes a semiconductor memory device according to the preamble of claim 1 wherein ground supply lines connected to capacitors of memory cells are independent and physically separated of other ground supply lines connected to peripheral circuits.

It is an object of the present invention to provide a semiconductor memory device provided with an improved power voltage supplying structure which contributes to a stable operation.

It is an other object of the present invention to provide a semiconductor read-only memory device which can operate stably without malfunction.

These objects are achieved by a semiconductor memory device as defined in claims 1 and 6, respectively. The dependent claims are related to further developments of the invention.

According to the present invention, the potential change in the first voltage at the one peripheral circuit due to the peak current thereof is hardly transmitted to the first voltage terminal because of the impedance element. Therefore, the other peripheral circuit is not affected by the potential change in the first voltage caused by the other peripheral circuit so that the other peripheral circuit can operate stably.

## BRIEF DESCRIPTION OF THE DRAWINGS

The above and further objects, features and advantages of the present invention will become more apparent from the following detailed description taken in conjunction with the accompanying drawings, wherein:

Fig. 1 is a schematic block diagram showing one prior art example of semiconductor memory device;

Fig. 2 is a schematic block diagram of a sense amplifier employed in the memory of Fig. 1;

Figs. 3A and 3B are diagrams showing operation of the memory of Fig. 1;

Fig. 4 is a timing diagram showing operation of the memory of Fig. 1;

Fig. 5 is schematic diagram showing another prior art example of memory device;

Fig. 6A, 6B, 6C and 6D are diagrams for explaining operation of the memory of Fig. 5;

Fig. 7 is a schematic block diagram of a memory device according to a first embodiment of the present invention;

Fig. 8 is a timing diagram showing operation of the memory of Fig. 7;

Fig. 9 is a schematic block diagram of a memory device according to a second embodiment of the present invention;

Fig. 10 is a schematic block diagram of a memory device according to a third embodiment of the present invention;

Fig. 11 is a schematic circuit diagram of a memory cell employed in the memory of Fig. 10;

Fig. 12 is a sectional diagram showing a P-channel field effect transistor;

Fig. 13 is a schematic block diagram showing a memory device according to a fourth embodiment of the present invention;

Fig. 14 is a schematic circuit diagram of the memory cell block of the memory of Fig. 13;

Fig. 15 is a circuit diagram of the NOR gate;

Fig. 16 is a schematic circuit diagram of the two-input NAND gate;

Fig. 17 is a schematic circuit diagram of the three-input NAND gate;
Fig. 18 is a schematic equivalent circuit diagram of the memory of Fig. 13; and
Fig. 19 is a schematic block diagram of a memory device according to a fifth embodiment of the present invention.

DETAILED DESCRIPTION OF THE INVENTION

Prior Art:

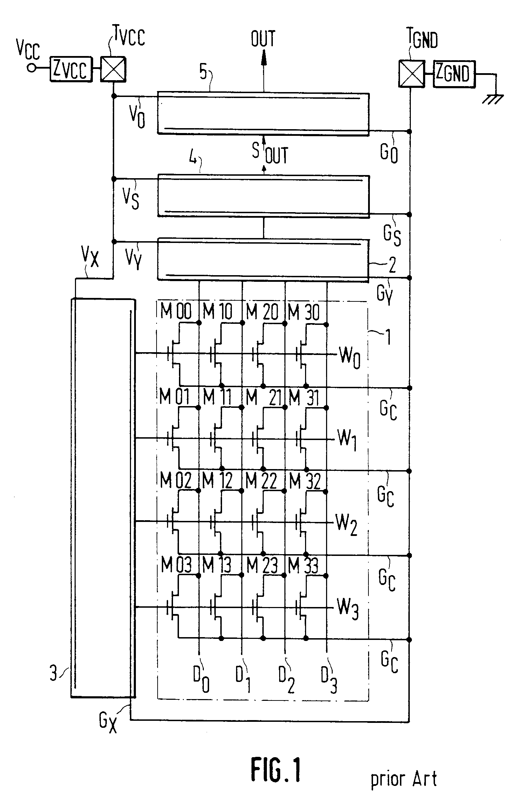

One example of a memory device in the prior art will be explained with reference to Figs. 1 to 4.

As shown in Fig. 1, a conventional semiconductor memory device comprises a memory cell array 1 formed by arranging a plurality of memory cells M00 - M33 in both column and row directions; a plurality of column lines D0 - D3 for connecting the memory cells M00 - M33 in the column direction; a plurality of row (word) lines W0 - W3 for connecting the memory cells M00 - M33 in the row direction; a column selection circuit for receiving address signal and selecting the column lines D0 - D3; a row selection circuit 3 for receiving row address signals and selecting one of the row lines W0 - W3; a sense amplifier 4 for reading out data stored in the selected memory cell in the memory cell array 1; and an output buffer 5 for driving a load connected to an output terminal OUT. Ground wirings GC of the memory cells M00 - M33, a ground wiring GY of the column selection circuit 2, a ground wiring GX of the row selection circuit 3, a ground wiring GS of the sense amplifier 4 and a ground wiring GO of the buffer 5 are connected to a ground terminal TGND formed as a bonding pad, and a power source wiring VY of the column selection circuit 2, a power source wiring VX of the row selection circuit 3, a power source wiring VS of the sense amplifier 4 and a power source wiring VO of the buffer 5 are connected to a power source terminal TVCC formed as a bonding pad.

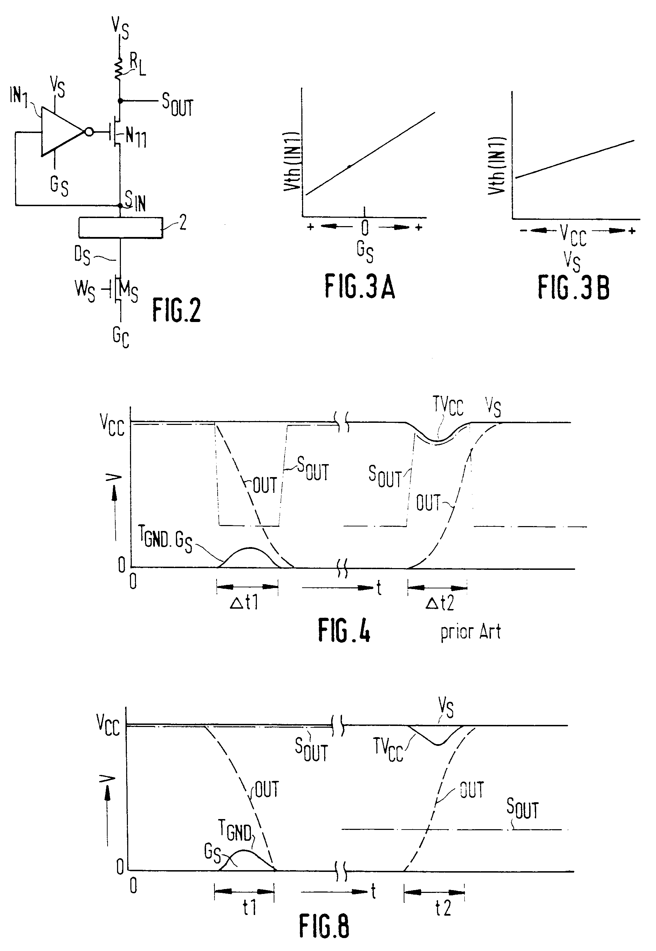

Next, operation of this memory will be explained briefly with reference to Fig. 2. As shown in Fig. 2, the sense amplifier 4 is comprised of an N-channel MOSFET N11 whose drain and gate are connected to the sense amplifier output SOUT and to the output of an inverter IN1, respectively. A load resistor RL is connected between the power source wiring VS of the sense amplifier and its output SOUT and if the input of the inverter IN1 and the power source and the ground are connected to the sense amplifier input SIN, to the power source wiring VS of the sense amplifier and to the ground wiring GS of the sense amplifier, respectively. When the selected memory cell at the point of intersection between the column line Di $(0 \leqq i \leqq 3)$ selected by the column selection circuit 2 and the row line Wj $(0 \leqq j \leqq 3)$ selected by the row selection circuit 3 is programmed non-conductive, the sense amplifier input SIN and the selected column line DS are biased to a logical threshold voltage Vth of the inverter INV 1 as the operating voltage of the sense amplifier and the output of the inverter IN1 is below Vth + VTN (where VTN is a logical threshold voltage of the N-channel MOSFET) so that the N-channel MOSFET 11 is turned OFF, too, and the sense amplifier output SOUT is pulled up by the load resistor RL to the potential of the power source wiring VS of the sense amplifier, thereby outputting a high level. When the selected memory cell MS is programmed conductive, on the other hand, the sense amplifier input SIN and the selected column line Di are biased to the logical threshold voltage Vth of the inverter IN1 and its output becomes Vth + VNT + $\alpha$ (e.g. $\alpha = 0.5$ V). Accordingly, the N-channel MOSFET N11 is turned ON, a current is supplied to the selected memory cell MS through the load resistor RL and the N-channel MOSFET N11, the voltage drop occurs through the load resistor RL and a low level is outputted from the sense amplifier output SOUT.

In the conventional semiconductor memory device described above, the ground wiring GS and power source wiring VS of the sense amplifier 4 and the ground wiring GO and power source wiring VO of the buffer 5 are commonly connected to the ground terminal TGND and to the power source terminal TVCC, respectively, as shown in Fig. 1. Therefore, if a heavy load is connected to OUT and driven by the buffer 5, a large current flows through the ground wiring GO or the power source wiring VO and thus noise is applied (for the periods $\Delta t1$ and $\Delta t2$) to the ground terminal TGND and the power source terminal TVCC as shown in Fig. 4 because parasitic impedances ZGND and ZVCC exist between the ground terminal TGND and a ground voltage source GND and between the power source terminal TVCC and a power source VCC, respectively. This noise is carried to the ground wiring GS and power source wiring VS of the sense amplifier 4, causing thereby an erroneous operation of the sense amplifier 4.

Hereinafter, the operation of the sense amplifier 4 when the noise is carried to the ground wiring GS and power source wiring VS of the sense amplifier 4 will be explained briefly. First of all, when the potential of the ground wiring GS of the sense amplifier 4 rises in the period $\Delta t1$ in Fig. 4, the logical threshold voltage Vth of the inverter IN1 rises as shown in Fig. 3A and the output of the inverter IN1 rises, too. Therefore, if the selected memory cells MS is non-conductive, the N-channel MOSFET N11, which should be turned OFF, is turned ON and the low level as the erroneous output is outputted from the sense amplifier output SOUT for the period $\Delta t1$. If the potential of the power source wiring VS of the sense amplifier 4 drops in the period $\Delta t2$ in Fig. 4, on the other hand, the logical threshold voltage Vth of the inverter IN1 drops as shown in Fig. 3B and the output of the inverter IN1 drops, too. Accordingly, when the selected memory cell MS is conductive, the N-channel MOSFET N11, which should be ON, is turned OFF and the high level as the erroneous output is outputted from the sense amplifier output SOUT for the period t2.

Furthermore, since the ground wiring GY of the column selection circuit 2 is directly connected to the ground terminal TGND, the column lines under the non-selection state enter erroneously the selection state if the rise of the potential of the ground terminal TGND exceeds the threshold voltage of the N-channel MOSFET forming the column selection circuit 2. Since the ground wiring GX of the row selection circuit 3 is directly connected to the ground terminal TGND, the memory cells under the non-selection state enter erroneously the selection stage because the potential of the non-selected word lines reaches substantially the same potential as the potential of the ground terminal TGND if the rises of the potential of the ground terminal TGND is above the threshold voltage of the memory cells.

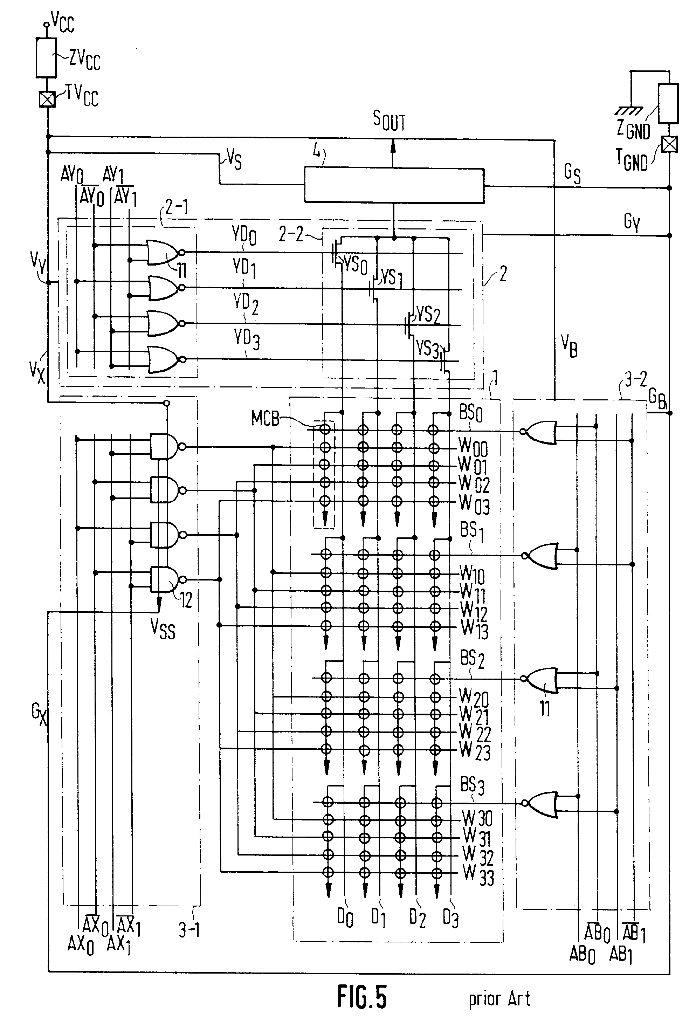

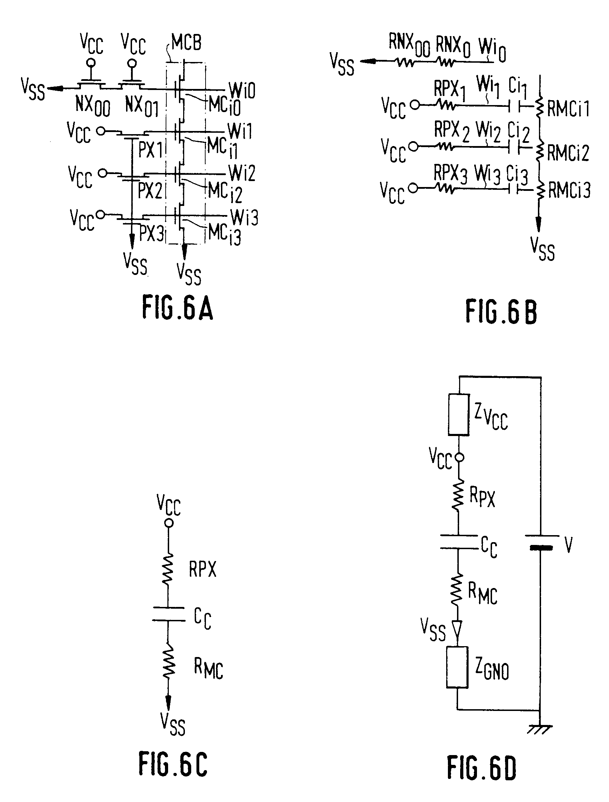

Another example of the memory device in the prior art will be explained with reference to Figs. 5, 6A, 6B, 6C and 6D. This memory device is the so-called series-connection type read-only memory.

As shown in Fig. 5, the series-connection type ROM comprises memory cell blocks MCB each including a series circuit of four memory cells MCi0 - MCi3 constituted by N-channel MOSFETs as shown in Fig. 6A, for example, and an N-channel block select MOSFET MSi; a memory cell array 1 formed by arranging a plurality of memory cell blocks MCB in row and column directions; an column selection circuit 2, connected to a plurality of column lines D0 - D3 for selecting the memory cell blocks in the column direction, a plurality of row lines WO0 - WO33 for connecting the memory cells MCi0 - MCi3 forming the memory cell block MCB in the row direction, a column decoder 2-1 for inputting address signals AY0 - $\overline{AY1}$ and a column selector 2-2 having N-channel MOSFETS YS0 - YS3 driven by the outputs YD0 - YD3 of the decoder 2-1, for selecting the column lines D0 - D3; a row selection circuit 3-1 for receiving the address signals AX0 - $\overline{AX1}$ and selecting the row lines W00 - W33; a memory cell block selection circuit 3-2 for receiving the address signals AB0 - $\overline{AB1}$ and selecting the memory cell blocks MCB by driving the selection MOSFET Msi; and a sense amplifier 4 for reading out data stored in the selected memory cell in the memory cell array 1.

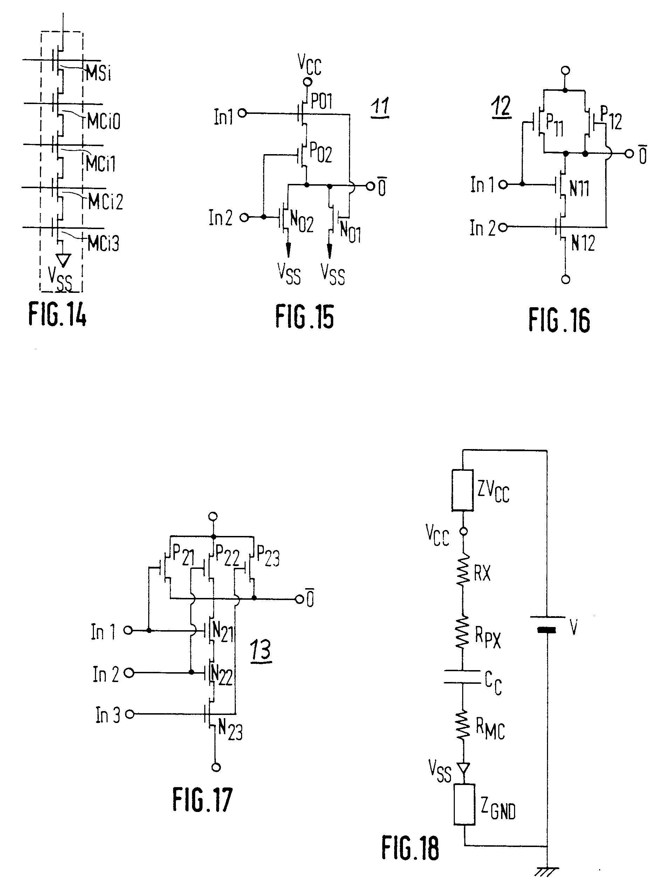

In Fig. 5, each NOR gate 11 forming the decoder 2-1 and the memory cell block selection circuit 3-2 includes P-channel MOSFETs P01, P02 and N-channel MOSFETs N01, N02 as shown in Fig. 15 and is interposed between a power source terminal Vcc and a ground terminal Vss. Each NAND gate 12 in the row selection circuit 3-1 in Fig. 5 includes P-channel MOSFETs P11, P12 and N-channel MOSFETs N11, N12, as shown in Fig. 16.

Next, the operation of this memory will be described briefly. If, for example, the address signals AY0 and AY1 are at the high level, the output YD0 of the decoder 2-1 is at the high level with the outputs YD1 - YD3 being at the low level, the N-channel MOSFETs YS0 forming the selector 2-2 is ON with the transistors YS1 - YS3 being OFF and the column line D0 is selected. If the address signals AB0 and AB1 are at the high level, the output BS0 of the memory cell block selection circuit is at the high level with the outputs BS1 - BS3 being at the low level and the selection MOSFETs forming the memory cell block driven by the output BS0 of the selected memory cell block selection circuit are turned ON. Accordingly, they are connected to the selected column line D0 and the memory cell block where the selection MOSFET driven by the selected memory cell block circuit exists is selected. Furthermore, if the address signals AX0 and AX1 are at the high level, the row lines W00, W10, W20 and W30 are at the low level and are selected while the row lines W01 - W03, W11 - W13, W21 - W23 and W31 - W33 are at the high level and are not selected, and the memory cell which exists inside the selected memory cell block and is moreover driven by the selected row line is under the selection state. If the selected memory cell is an N-channel depletion MOSFET, it is ON even at a low gate potential level. Accordingly, the selected column line D0 and the ground terminal Vss are connected electrically to each other through the selection MOSFET. If the selected memory cell is an N-channel enhancement MOSFET, on the other hand, it is turned OFF because the gate potential is at the low level so that the selected column line D0 and the ground terminals Vss are electrically cut off. The sense amplifier 4 detects whether or not the selected column line D0 and the ground terminal Vss are electrically connected, and reads out the data stored in the memory cell.

In this ROM described above, since the power source is connected directly to the row selection circuit 3-1, the power source terminal and the ground terminal coupled with each other at a low impedance and the noise of the power terminal is transmitted to the ground terminal or the noise at the ground terminal is transmitted to the power terminal, causing thereby an erroneous operation of the sense amplifier or the like.

In this ROM, the selected row line Wi0 is connected to the ground terminal Vss through the N-channel MOSFETs NXO0 and NXO forming the row selection circuit and the non-selected row lines Wi1, Wi2 and Wi3 are connected to the power source terminal Vcc through the P-channel MOSFETs PX1, PX2 and PX3, as shown in Fig. 6A. Here, an equivalent circuit such as shown in Fig. 6B can be obtained by replacing the N-channel MOSFETs NXO0 and NXO by resistors RNXO0 an RNXO, the P-channel MOSFETs PX1, PX2 and PX3 by resistors RPX1, RPX2 and RPX3, expressing the gate capacitances of the non-selected memory cells MCi1, MCi2 and MCi3 to the gate of which the power source voltage is applied by Ci1, Ci2 and Ci3 and expressing the ON resistances by RMCi1, RMCi2 and RMCi3. The gate capacitance and ON resistance of the selected memory cell MCi0 are not shown in Fig. 6B. For, if the selected memory cell MCi0 is of the N-channel enhancement MOSFET, it is turned OFF because the gate is at the ground potential. If the selected memory cell MCi0 is of the N-channel depletion MOSFET, it is turned ON and the ON resistance is connected to the ground terminal Vss through the gate capacitance and the resistors RNXO0 and RNXO. However, the operation in this case is substantially the same as that of the N-channel enhancement MOSFET, the explanation of the N-channel depletion MOSFET as the selected memory cell MCi0 will be omitted.

Furthermore, an equivalent circuit shown in Fig. 6C can be obtained by connecting parallel the resistors RPX1, RPX2 and RPX3 of Fig. 6B and replacing them by a resistor RPX, connecting the gate capacitances Ci1, Ci2 and Ci3 and replacing them by a capacitance CC and connecting in series the ON resistances RMCi1, RMCi2 and RMCi3 and replacing them by a resistor RMC. In a large capacity ROM having a large number of memory cell, RPX = 1.0 $\Omega$, CC = 10,000 pF, RMC = 0.1 $\Omega$, for example.

Here, parasitic impedances ZVCC and ZGND exist between the power source and the power source terminal Vcc and between the ground power source and the ground terminal Vss and they are, for example, $|ZVCC| = 10\,\Omega$ and $|ZGND| = 10\,\Omega$, and $|RPX + 1/jWCC + RMC| = 1.1\,\Omega$ (W = $2\pi f$:f = 100 MHz is hereby assumed). When the parasitic impedances ZVCC and ZGND existing between the power source v and the power source terminal VCC and between the power source v and the ground terminal VSS are compared, the power source terminal VCC and the ground terminal VSS are coupled by an impedance as low as 1.1 $\Omega$. When a noise of 1.0 V and f = 100 MHz is contained at the power source terminal VCC, for example, the noise VNGND transmitted to the ground terminal VSS is expressed by the following formula:

$$VNGND = 1.0\,V \times |ZGND| / |ZGND| + |RPX + 1/jWCC + RMC| = 0.9\,V$$

As can be understood from the result of the formula given above, the noise at the power source terminal VCC is transmitted substantially completely to the ground terminal VSS and the ground of the sense amplifier or the like, too, is connected to the ground terminal VSS. Accordingly, the sense amplifier or the like operates erroneously due to the noise transmitted to the ground terminal VSS. If the noise of 1.0 V and f = 100 MHz exists at the ground terminal VSS, the noise VNVCC transmitted to the power source terminal VCC is likewise given as follows:

$$VNVCC = 1.0\,V \times |ZVCC| / |ZVCC| + |RPX + 1/jWCC + RMC| = 0.9\,V$$

Therefore, the noise at the ground terminal VSS, too, is transmitted substantially completely to the power source terminal VCC, and since the power source of the sense amplifier or the like is connected to this power source terminal VCC, the sense amplifier or the like often operates erroneously due to the noise transmitted to the power source terminal VCC.

Embodiments:

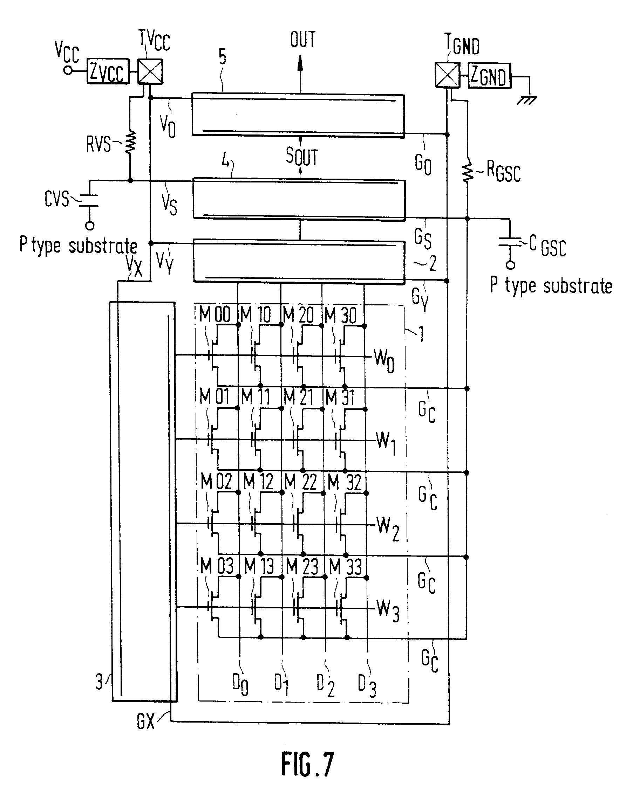

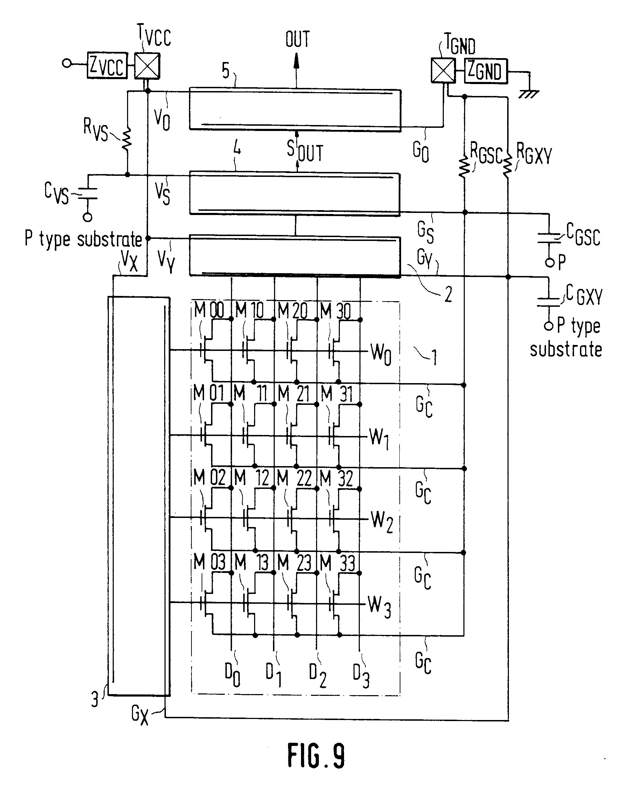

With reference to Figs. 7 and 8, the memory device according to a first embodiment of the present invention will be explained. This embodiment relates the case where the conventional memory device of Fig. 1 is improved according to the present invention.

In Fig. 7, elements or portions corresponding to those of Fig. 1 are denoted by the same or similar references employed in Fig. 1.

As shown in Fig. 7, the memory device comprises a memory cell array 1 formed by arranging a plurality of memory cells M00 - M33 in both column and row directions; a plurality of column lines D0 - D3 for connecting the memory cells M00 - M33 in the column direction; a plurality of row lines W0 - W3 for connecting the memory cells M00 - M33 in the row direction; a column selection circuit for receiving column address signals and selecting the column lines D0 - D3; a row selection circuit 3 for receiving row address signals to select one of the row lines W0 - W3; a sense amplifier 5 for reading out data stored in the selected memory cell in the memory array 1; and an output buffer 5 for driving a load. The semiconductor memory device of the present embodiment is characterized in that the ground wirings GC of the memory cells M00 - M33 forming the memory cell array 1 are connected to the ground wiring GS of the sense amplifier and then to the ground terminal TGND formed as a bonding pad on the semiconductor substrate through a first resistance element RGSC and the power source wiring VS of the sense amplifier 4 is connected to the power source terminal TVCC formed in the form of a bonding pad through a third resistance element RVS.

The ground wirings GY, GX and GO of the column selection circuit 2, the row selection circuit 3 and the buffer 5 are directly connected to the ground terminal TGND and to the powder source terminal TVCC. The ground terminal TGND is connected to the ground voltage source through a parasitic impedance ZGND and the power source terminal TVCC is connected to the power source VCC through the parasitic impedance ZVCC.

If each memory cell M00 - M33 is a ROM cell consisting of an N-channel MOSFET formed on a P-type substrate, the source S of each memory cell M00 - M33 and the ground wiring GC are connected. Therefore, an extremely great junction capacitance CGSC (e.g. CGSC = 2,000 pF) exists between the ground wiring GC of each memory cell M00 - M33 and the P-type substrate. Incidentally, CGSC contains the junction capacitance between MOSFET forming the sense amplifier and the P-type substrate and the parasitic capacitance between the wirings and the P-type substrate. The parasitic capacitance CVS exists also between the power source wiring VS of the sense amplifier 4 and the P-type substrate.

Next, the operation will be explained briefly with reference also to Fig. 8. First of all, when the buffer 5 drives a heavy load and the buffer output OUT changes from the high level to the low level in the period $\Delta t1$ and when a large current thus flows through the ground wiring GO of the buffer 5, the noise is carried to the ground terminal TGND because a parasitic impedance ZGND exists between the ground terminal TGND and the ground GND, as shown in Fig. 8. However, the ground wirings GC of the memory cells M00 - M33 and the ground wiring GS of the sense amplifier 4 are connected to the ground terminal TGND through a first resistance element (RGSC, e.g. RGSC = 50 Ω) and moreover, an extremely great capacitance CGSC exists between the junction of the ground wirings GC of the memory cells M00 - M33 with the ground wiring GS of the sense amplifier 4 and the P-type substrate. Therefore, CGSC x RGSC = 2,000 pF x 50Ω = 100 nsec. If the period $\Delta t1$ in which the noise is carried to the ground terminal TGND is below 10 to 20 nsec, the noise is not transmitted to the ground wirings GC of the memory cells M00 - M33 and to the ground wiring GS of the sense amplifier 4 so that the potential of the ground wiring GS of the sense amplifier 4 does not change and the sense amplifier 4 does not operate erroneously, either. Incidentally, if the resistance value of the first resistance element RGSC is about 50 Ω, any adverse influences are not exerted on the memory cells M00 - M33 and the sense amplifier 4.

When the buffer 5 drives a heavy load, the buffer output OUT changes from the low level to the high level in the period $\Delta t2$ and a large current flows through the power source wiring VO of the buffer 5, the noise is carried to the power source terminal TVSS because a parasitic impedance ZVCC exists between the power source terminal TVCC and the power source VCC, as shown in Fig. 8. However, the power source wiring VS of the sense amplifier 4 is connected to the power source terminal through a third resistance element RVS and moreover, a capacitance CVS exists between the power source wiring VS of the sense amplifier 4 and the P-type substrate. Accordingly, the noise carried to the power source terminal TVCC is not transmitted to the power source wiring VS of the sense amplifier 4 so that the potential of the power source wiring VS of the sense amplifier 4 does not change and the sense amplifier 4 does not either operate erroneously.

Obviously, transmission of the noise becomes more difficult by increasing the capacitance CGSC by connecting the first capacitance element to the junctions of the ground wirings GC of the memory cells M00 - M33 with the ground wiring GS of the sense amplifier 4 or by increasing the capacitance CVS by connecting a third capacitance element between the power source wiring VS of the sense amplifier 4 and the P-type substrate. Therefore, its explanation will be hereby omitted.

Besides the ROM cell shown in Fig. 7, the similar effect can obviously be obtained by use of electrically writable memory cells having a floating gate type cell and a series connection type ROM memory cell formed by connecting a plurality of MOSFETs.

Fig. 9 is a circuit diagram showing the second embodiment of the present invention. The ground wiring GY of the column selection circuit 2 and the ground wiring GX of the row selection circuit 3 are connected and they are then connected to the ground terminal TGND through a second resistance element RGXY. A parasitic capacitance CGXY exists between the junction of the ground wiring GY of the column selection circuit 2 with the ground wiring GX of the row selection circuit 3 and the P-type substrate. Since the rest of portions are the same as those in the first embodiment shown in Fig. 7, like reference numerals are put to them and their explanation will be hereby omitted.

In addition to the effect of the first embodiment, the second embodiment provides the following effects. Namely, since the second resistance element RGXY and the parasitic capacitance CGXY exist, the noise applied to the power source terminal TVCC is not transmitted to the ground wiring GY of the column selection circuit 2 and to the ground wiring GX of the row selection circuit 3 so that the potential of the ground wiring GY of the column selection circuit 2 and the potential of the ground wiring GX of the row selection circuit 3 do not change and the erroneous operation in which the non-selected column lines and memory cells are brought into the selection state does not occur.

Obviously, transmission of the noise becomes more difficult if the capacitance CGXY is increased by connecting a second capacitance element between the junction of the ground wiring GY of the column selection circuit 2 with the ground wiring GX of the row selection circuit 3 and the P-type substrate, and its explanation will be hereby omitted.

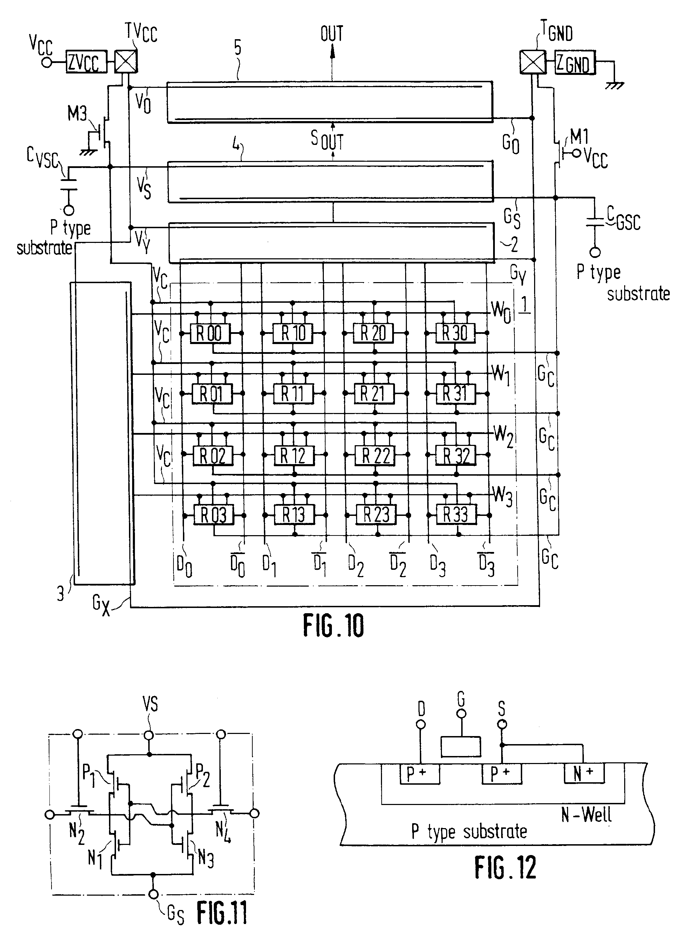

Fig. 10 is a circuit diagram showing the third embodiment of the present invention. As shown in Fig. 11, each memory cell R00 - R33 is a static memory cell having P-channel MOSFETs P1, P2 and N-channel MOSFETs N1, N2, N3, N4 and includes the power source wiring VC in addition to the ground wirings GS, and these memory cells R00 - R33 together constitute the memory cell array 1. The ground wirings GC of these memory cells R00 - R33 are connected to the ground wiring GS of the sense amplifier 4 and are then connected to the ground terminal TGND through an N-channel type first MOSFET M1 whose gate receives the power source VCC. The power source wirings VC of the memory cells R00 - R33 and the power source wiring VS of the sense amplifier 4 are connected and are then connected to the power source terminal TVCC through a P-channel type third MOSFET M3 whose gate is connected to the ground. Since the power source VCC is applied to the gate of the first MOSFET M1 and this transistor M1 is ON, it operates as a resistor and is equivalent to the first resistance element RGSC of the first embodiment. Accordingly, the similar effect to that of the first embodiment can be obtained obviously and its explanation will be hereby omitted. Since the gate of the third MOSFET M3 is connected to the ground and this transistor M3 is ON, it operates as a resistor and furthermore, since the power source wirings VC of the memory cells R00 - R33 are connected to the sources and N-wells of the P-channel MOSFETs P1, P2 constituting the memory cells R00 - R33 (as shown in Fig. 12), the junction capacitance between the N-well and the P-type substrate exists between the power source wirings VC of the memory cells R00 - R33 and the P-type substrate. In other words, since the capacitance CVSC exists between the junction of the power source wirings VC of the memory cells R00 - R33 with the power source wirings VS of the sense amplifier 4 and the P-type substrate, the similar effect to that of the first embodiment can be obtained obviously and the explanation of the operation will be hereby omitted.

In the third embodiment described above, the power source wirings VC of the memory cells R00 - R33 are connected to the power source wiring VS of the sense amplifier 4. Accordingly, the capacitance CVSC is greater than the capacitance CVS existing between the power source wiring VS and the P-type substrate in the first embodiment and transmission of the noise becomes more difficult.

Incidentally, transmission of the noise becomes obviously more difficult by increasing the value of the capacitance CVSC by connecting a third capacitance between the junction of the power source wirings VC of the memory cells R00 - R33 with the power source wiring VS of the sense amplifier 4 and the P-type substrate, and its explanation will be hereby omitted.

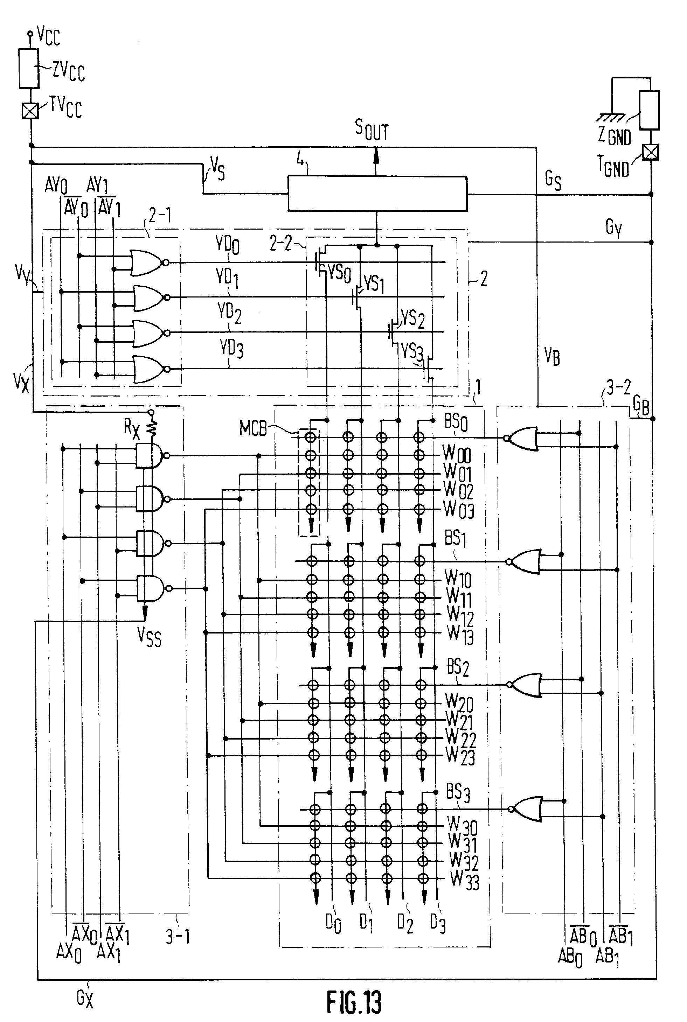

With reference to Fig. 13 to 18, the memory device according to the fourth embodiment of the present invention will be explained.

This embodiment relates to the case where the present invention is applied to the memory device of Fig. 5.

The memory device of this embodiment comprises a memory cell array 1 formed by arranging a plurality of memory cell blocks MCB both row and column directions each of the memory cell blocks MCB having a series circuit of four memory cells MCi0 - MCi3 consisting of N-channel MOSFETs and an N-channel selection MOSFET MSi for selecting them, as shown in Fig. 14 a column selection circuit 2 selecting one of a plurality of column lines D0 - D3 for connecting the memory cell blocks MCB in the column direction, a plurality of row lines W00 - W33 for connecting the memory cells MCi0 - MCi3 constituting the memory cell blocks MCB in the row direction, a column decoder 2-1 for receiving column address signals AY0 - $\overline{AY1}$ and a column selector 2-2 having N-channel MOSFETs YS0 - YS3 driven by the outputs YD0 - YD3 of the column decoder 2-1, for selecting the column lines D0 - D3; a row selection circuit 3-1 receiving the row address signals AX0 - $\overline{AX1}$ and selecting the row lines W00 - W33; a memory cell block selection circuit 3-2 receiving the address signals AB0 - $\overline{AB1}$ to drive the selection MOSFET MSi and selecting the memory cell blocks 1; and a sense amplifier 4 for reading out data stored in the selected memory cell in the memory cell array 1. In the above arrangement, NAND gates 12 forming the row selection circuit 3-1 are connected to the power source terminal VCC through the resistance element RX. Incidentally, the structure of NOR gates 11 forming the column decoder 2-1 and the memory cell block selection circuit 3-2 is shown in Fig. 15 and the structure of the NAND gates 12 forming the row selection circuit 3-1 is shown in Fig. 16.

Next, since the read operation of the data stored in the selected memory cell in the memory cell array 1 is exactly the same as that of the conventional ROM described with reference to Fig. 5, the explanation will be hereby omitted.

In the embodiment shown in Fig. 13, the NAND gates 12 forming the row selection circuit 3-1 are connected to the power source terminal VCC through the resistance element RX. Therefore, an equivalent circuit which is equivalent to the P-channel MOSFETs forming the power source terminal VCC - the resistor element RX - the row selection circuit 3-1 and which consists of the resistor RPX - memory cell gate capacitance CC - memory cell ON resistance RMC - ground terminal VSS is shown in Fig. 18. Furthermore, parasitic impedances ZVCC and ZGND exist between the power source and the power source terminal VCC and between the ground source and the ground terminal VSS. If RX = 100 $\Omega$, RPX = 1.0 $\Omega$, CC = 10,000 pF, RMC = 0.1 $\Omega$, $|ZVCC|$ = 100 $\Omega$ and $|ZGND|$ = 10 $\Omega$, in Fig. 3, $|RX + RPX + 1/jWCC + RMC|$ = 101.1 $\Omega$ (W = 2 f : f = 100 MHz is hereby assumed). Since the power source terminal VCC and the ground terminal VSS are coupled with a high impedance of 101.1 $\Omega$ in comparison with ZVCC and ZGND, if the noise of 1.0 V and f = 100 MHz exists at the power source terminal VCC, the noise VNGND transmitted to the ground terminal VSS is expressed by the formula below:

$$VNGND = 1.0 \text{ V} \times |ZGND| / |RX + RPX +$$

1/jWCC + RMC⏐ + ⏐ZGND⏐ = 0.09 V

From the result given above, the noise existing at the power source terminal VCC is below 1/10 and is hardly transmitted to the ground terminal VSS. Accordingly, the sense amplifier or the like does not operate erroneously due to the nosie transmitted to the ground terminal VSS.

When the noise of 1.0 V and f = 100 MHz is applied to the ground terminal VSS, the noise NVCC transmitted to the paper source terminal VCC is likewise given as follows:

VNVCC = 1.0 V x ⏐ZVCC⏐/⏐ZVCC⏐ + ⏐RX + RPX + 1/jWCC + RMC⏐ = 0.09 V

Accordingly, the noise applied to the ground terminal VSS is hardly transmitted, either, to the power source terminal VCC and the sense amplifier or the like does not operate erroneously due to the noise transmitted to the power source terminal VCC.

Incidentally, in the embodiment shown in Fig. 13, if the address signal AX0 - $\overline{AX1}$ changes, the output of one selected NAND gate among the four NAND gates 12 forming the row selection circuit 3-1 changes from the high level to the low level and the output of one non-selected NAND changes from the low level to the high level but the outputs of the remaining two NANDs are kept at the high level. Since the gate capacitance of the memory cells connected to the outputs of these NANDs keeping the high level operate as the smoothing capacitance, any adverse influences are not exerted on the operation of the row selection circuit 3-1 even though the NAND gates constituting the row selection circuit 3-1 and the power source terminal VCC are connected to each other through the resistance element RX of about 100 Ω. Moreover, in a practical vertical ROM, each memory cell block consists of eight or sixteen memory cells and among the NAND gates 12 forming the row selection circuit, six among eight or fourteen among sixteen keep the high level even if the address signal changes. In consequence, the gate capacitances of the memory cells connected to the outputs of these NAND gates 12 keeping the high level become an extremely great smoothing capacitance and the resistance element RX of about 100 Ω or so does not at all affect adversely the operation of the row selection circuit. Obviously, the similar effect can be obtained by connecting an N-channel MOSFET whose gate is connected to the power source terminal VCC in place of the resistance element RX.

Second Embodiment:

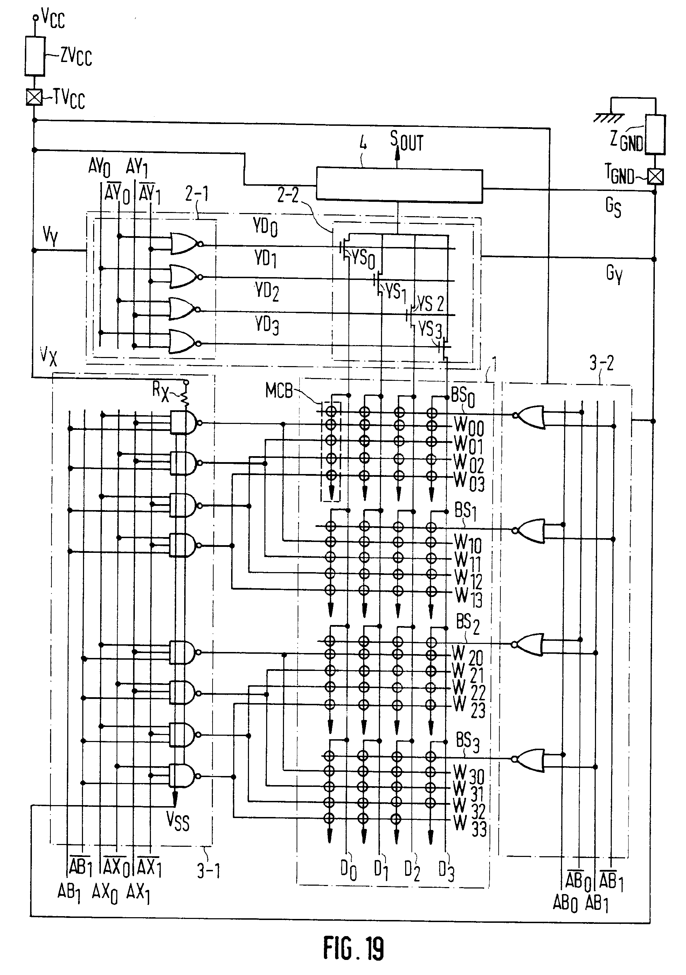

Fig. 19 is a circuit diagram showing the fifth embodiment of the present invention. The circuit of this embodiment has the structure wherein the NAND gates forming the row selection circuit 3-1 of the forth embodiment shown in Fig. 13 are replaced by three-input NAND gates 13 shown in Fig. 17. The NAND gate 13 for driving the column lines W00 - W13 and the NAND gate 13 for driving the column lines W20 - $\overline{W33}$ are disposed, and the address signals AB1 and $\overline{AB1}$ inputted to the memory cell block selection circuit 3-2 are applied to the NAND gates for driving the column line W00 - W13 and to the NAND gates for driving the column lines W20 - W33 so that either one of the NAND gates for driving the column lines W00 - W13 and the NAND gates for driving the column lines W20 - W33 are selected.

In the fifth embodiment shown in Fig. 19, the NAND gates 13 forming the row selection circuit 3-1 are connected to the power source terminal VCC through the resistor element RX. Therefore, the similar effect to that of the fourth embodiment can be obtained obviously and the description is therefore omitted.

If, for example, the address signals AB1 and AX1 are at the high level and the address signal AX0 changes from the high level to the low level, the four column lines, i.e., W00, W10, W20 and W30, in the embodiment shown in Fig. 13, change from the low level to the high level and enter the non-selection state and the four column lines W01, W11, W21 and W31 change from the high level to the low level and enter the selection state. Furthermore, the column lines W02, W03, W12, W13, W22, W23, W32 and W33 keep the high level. In the embodiment shown in Fig. 19, however, two column lines W00 and W10 change from the low level to the low level and enter the non-selection state, two column lines W01 and W02 the selection state and twelve column lines W02, W03, W12, W13, W20 - W23 and W30 - W33 keep the high level. Accordingly, the smoothing capacitance becomes greater (1.5 times in this embodiment) and the resistance element RX connected tothe NANDs constituting the row selection circuit 3-1 and to the power source terminal VCC can be set to a greater value. In other words, the impedance between the power source terminal VCC and the ground terminal VSS can be set to a higher value and it becomes further difficult for the noise existing at the power source terminal VCC to be transmitted to the ground terminal VSS. Similarly, it becomes further difficult for the noise existing at the ground terminal VSS to be transmitted to the power source terminal VCC.

As described above, according to the present invention the power source is connected to the buffer or the row selection circuit through the resistance element and therefore it provides the effect of preventing the erroneous operation of the other circuit blocks such as sense amplifier or the like due to the noise transmitted from the power source terminal to the ground terminal or vice versa.

## Claims

1. A semiconductor memory device comprising a memory cell array (1) having a plurality of memory cells, a first voltage terminal (TGND) for receiving a first voltage, a first peripheral circuit (2, 3) for operatively selecting at least one of said memory cells, a second peripheral circuit (4) for operatively reading out a signal from the selected memory cell, a first power wiring (GX, GY) for connecting said first peripheral circuit to said first voltage terminal, and a second wiring (GS) for connecting said second peripheral circuit to said first voltage terminal characterized in that said memory device further comprises a first impedance element (RGSC, M1) inserted between said second wiring (GS) and said first voltage terminal (TGND) and that said first wiring connects said first peripheral circuit to said first voltage terminal without an intervention of said first impedance element.

2. The memory device as claimed in claim 1, characterized in that said second peripheral circuit comprises a sense amplifier for amplifying the signal from said selected memory cell.

3. The memory device as claimed in claim 1 and 2, characterized by further comprising a third wiring (GS) for connecting said memory cell array (1) to said first voltage terminal through said first impedance element.

4. The memory device as claimed in claim 2, further comprising an output buffer circuit (5) for receiving an output from said sense amplifier and producing an output data signal and a fourth wiring (GO) for connecting said output buffer circuit to said first voltage terminal without an intervention of said first impedance element.

5. The device as claimed in claim 1, 2 or 3, further comprising a second voltage terminal (TVCC) for receiving a second voltage, an additional first wiring (VX, VY) for connecting said first peripheral circuit to said second voltage terminal and an additional second wiring (VS) for connecting said second peripheral circuit to said second voltage terminal, characterized in that said memory device further comprises a second impedance element (RVS) inserted between said additional second wiring and said second voltage terminal.

6. A read-only semiconductor memory device comprising a memory cell array (1) formed of a plurality of memory cell blocks (MCB) arranged in a matrix form of rows and columns, each of said memory cell blocks having a series circuit of a plurality of memory cells, a plurality of column lines (DO-D3) for connecting said memory cell blocks in the column direction, a plurality of row lines (W00-W33) for connecting said memory cells forming said memory cell blocks in the row direction, a column selection circuit (2) having a column decoder (2-1) for receiving column address signals and a column selector (2-2) driven by the output of said column decoder for selecting said column lines, a row selection circuit (3-1) for receiving row adress signals and selecting row lines, a memory cell block selection circuit (3-2) for receiving address signals to select said memory cell blocks, a sense amplifier (4) for reading out data stored in a selected one of said memory cells in said memory cell array, first and second voltage terminals (TVCC, TGND) for receiving first and second voltage, respectively, first and second wirings (VS, GS) for connecting said sense amplifier to said first and second voltage terminals, respectively, third and fourth wirings (VY, GY) for connecting said column selection circuit to said first and second voltage terminals, respectively, fifth and sixth wirings (VX, GX) for connecting said row selection circuit to said first and second voltage terminals, respectively, and seventh and eighth wirings (VB, GB) for connecting said memory cell block selection circuit to said first and second voltage terminals, respectively, wherein said memory device further comprises an impedance element (RX) inserted between said row selection circuit (3-1) and said fifth wiring (VX) to supply said first voltage at said first voltage terminal to said row selection circuit therethrough.

## Patentansprüche

1. Halbleiterspeichervorrichtung mit einem Speicherzellenfeld (1) mit einer Anzahl von Speicherzellen, einem ersten Spannungsanschluß (TGND) zum Empfang einer ersten Spannung, einer ersten Peripherieschaltung (2, 3) zum operativen Auswählen zumindest einer der Speicherzellen, einer zweiten Peripherieschaltung (4) zum operativen Auslesen eines Signals aus der ausgewählten Speicherzelle, einer ersten Versorgungsverdrahtung (GX, GY) zum Verbinden der ersten Peripherieschaltung mit dem ersten Spannungsanschluß, einer zweiten Verdrahtung (GS) zum Verbinden der zweiten Peripherieschaltung mit dem ersten Spannungsanschluß, dadurch **gekennzeichnet**, daß die Speichervorrichtung ferner ein erstes Impedanzelement (RGSC, M1) aufweist, das zwischen die zweite Verdrahtung (GS) und den ersten Spannungsanschluß (TGND) geschaltet ist, und daß die erste Verdrahtung die erste Peripherieschaltung mit dem ersten Spannungsanschluß ohne Zwischenfügung des ersten Impedanzelementes verbindet.

2. Speichervorrichtung nach Anspruch 1, dadurch **gekennzeichnet**, daß die zweite Peripherieschaltung einen Leseverstärker zum Verstärken des Signals aus der ausgewählten Speicherzelle aufweist.

3. Speichervorrichtung nach Anspruch 1 oder 2, **gekennzeichnet** durch ferner eine dritte Verdrahtung (GS) zum Verbinden des Speicherzellenfeldes (1) mit dem ersten Spannungsanschluß über das erste Impedanzelement.

4. Speichervorrichtung nach Anspruch 2, mit ferner einer Ausgangspufferschaltung (5) zum Empfangen eines Ausgangssignals von dem Leseverstärker und zum Erzeugen eines Ausgabedatensignals und mit einer vierten Verdrahtung (GO) zum Verbinden der Ausgangspufferschaltung mit dem ersten Spannungsanschluß ohne Zwischenschaltung des ersten Impedanzelementes.

5. Vorrichtung nach Anspruch 1, 2 oder 3, mit ferner einem Zweitspannungsanschluß (TVCC) zum Empfang einer zweiten Spannung, einer zusätzlichen ersten Verdrahtung (VX, VY) zum Verwenden der ersten Peripherieschaltung mit dem zweiten Spannungsanschluß und einer zusätzlichen zweiten Verdrahtung (VS) zum Verbinden der zweiten Peripherieschaltung mit dem zweiten Spannungsanschluß, dadurch **gekennzeichnet**, daß die Speichervorrichtung ferner ein zweites Impedanzelement (RVS) aufweist, das zwischen die zusätzliche zweite Verdrahtung und den zweiten Spannungsanschluß geschaltet ist.

6. Nur-Lese-Halbleitervorrichtung mit einem Speicherzellenfeld (1) aus einer Anzahl von Speicherzellblöcken (MCB), die in Matrixform aus Reihen und Spalten angeordnet sind, wobei jeder der Speicherzellblöcke eine Reihenschaltung aus einer Anzahl von Speicherzellen aufweist, mit einer Anzahl von Spaltenleitungen (D0-D3) zum Verbinden der Speicherzellblöcke in Spaltenrichtung, einer Anzahl von Zeilenleitungen (W00-W33) zum Verbinden der Speicherzellen, die die Speicherzellblöcke bilden, in Zeilenrichtung, einer Spaltenauswahlschaltung (2) mit einem Spaltendekoder (2-1) zum Empfangen von Spaltenadressignalen und einem Spaltenselektor (2-2), der durch das Ausgangssignal des Spaltendekoders betrieben wird, zum Auswählen der Spaltenleitungen, einer Zeilenauswahlschaltung (3-1) zum Empfangen von Zeilenadressignalen und zum Auswählen von Zeilenleitungen, einer Speicherzellblock-Auswahlschaltung (3-2) zum Empfangen von Adressignalen zur Auswahl der Speicherzellblöcke, einem Leseverstärker (4) zum Auslesen von in einer ausgewählten Speicherzelle des Speicherzellfeldes gespeicherten Daten, einem ersten und einem zweiten Spannungsanschluß (TVCC, TGND) zum Empfangen einer ersten bzw. einer zweiten Spannung, einer ersten und einer zweiten Verdrahtung (VS, GS) zum Verbinden des Leseverstärkers mit dem ersten bzw. dem zweiten Spannungsanschluß, einer dritten und einer vierten Verdrahtung (VY, GY) zum Verbinden der Spaltenauswahlschaltung mit dem ersten bzw. dem zweiten Spannungsanschluß, einer fünften und einer sechsten Verdrahtung (VX, GX) zum Verbinden der Zeilenauswahlschaltung mit dem ersten bzw. dem zweiten Spannungsanschluß, und einer siebten und einer achten Verdrahtung (VP, GB) zum Verbinden der Speicherzellblock-Auswahlschaltung mit dem ersten bzw. dem zweiten Spannungsanschluß, wobei die Speichervorrichtung ferner ein Impedanzelement (RX) aufweist, das zwischen die Spaltenauswahlschaltung (3, 1) und die fünfte Verdrahtung (VX) geschaltet ist, um die erste Spannung am ersten Spannungsanschluß dadurch zur Spaltenauswahlschaltung zu liefern.

## Revendications

1. Dispositif de mémoire à semiconducteur comprenant un réseau de cellules de mémoire (1) comportant une pluralité de cellules de mémoire, une première borne de tension (TGND) pour recevoir une première tension, un premier circuit périphérique (2, 3) pour sélectionner en fonctionnement au moins l'une desdites cellules de mémoire, un second circuit périphérique (4) pour lire en fonctionnement un signal sur la cellule de mémoire sélectionnée, un premier câblage d'alimentation (GX, GY) pour connecter ledit premier circuit périphérique à ladite première borne de tension et un second câblage (GS) pour connecter ledit second circuit périphérique à ladite première borne de tension, caractérisé en ce que ledit dispositif de mémoire comprend en outre un premier élément de d'impédance (RGSC, M1) inséré entre ledit second câblage (GS) et ladite première borne de tension (TGND) et en ce que ledit premier câblage connecte ledit premier circuit périphérique à ladite première borne de tension sans l'intervention dudit premier élément d'impédance.

**2.** Dispositif de mémoire selon la revendication 1, caractérisé en ce que ledit second circuit périphérique comprend un amplificateur de détection pour amplifier le signal provenant de ladite cellule de mémoire sélectionnée.

**3.** Dispositif de mémoire selon les revendications 1 et 2, caractérisé en ce qu'il comprend en outre un troisième câblage (GS) pour connecter ledit réseau de cellules de mémoire (1) à ladite première borne de tension par l'intermédiaire dudit premier élément d'impédance.

**4.** Dispositif de mémoire selon la revendication 2, comprenant en outre un circuit de tampon de sortie (5) pour recevoir une sortie provenant dudit amplificateur de détection et pour produire un signal de données de sortie et un quatrième câblage (GO) pour connecter ledit circuit de tampon de sortie à ladite première borne de tension sans l'intervention dudit premier élément d'impédance.

**5.** Dispositif selon la revendication 1, 2 ou 3, comprenant en outre une seconde borne de tension (TVCC) pour recevoir une seconde tension, un premier câblage supplémentaire (VX, VY) pour connecter ledit premier circuit périphérique à ladite seconde borne de tension et un second câblage supplémentaire (VS) pour connecter ledit second circuit périphérique à ladite seconde borne de tension, caractérisé en ce que ledit dispositif de mémoire comprend en outre un second élément d'impédance (RVS) inséré entre ledit second câblage supplémentaire et ladite seconde borne de tension.

**6.** Dispositif de mémoire morte à semiconducteur comprenant un réseau de cellules de mémoire (1) constitué par une pluralité de blocs de cellules de mémoire (MCB) agencés sous la forme d'une matrice de rangées et de colonnes, chacun desdits blocs de cellules de mémoire comportant un circuit série d'une pluralité de cellules de mémoire, une pluralité de lignes de colonne (D0-D3) pour connecter lesdits blocs de cellules de mémoire suivant la direction de colonne, une pluralité de lignes de rangée (W00-W33) pour connecter lesdites cellules de mémoire formant lesdits blocs de cellules de mémoire suivant la direction de rangée, un circuit de sélection de colonne (2) comportant un décodeur de colonne (2-1) pour recevoir des signaux d'adresse de colonne et un sélecteur de colonne (2-2) commandé par la sortie dudit décodeur de colonne pour sélectionner lesdites lignes de colonne, un circuit de sélection de rangée (3-1) pour recevoir des signaux d'adresse de rangée et pour sélectionner des lignes de rangée, un circuit de sélection de bloc de cellules de mémoire (3-2) pour recevoir des signaux d'adresse pour sélectionner lesdits blocs de cellules de mémoire, un amplificateur de sélection (4) pour lire les données stockées dans l'une sélectionnée desdites cellules de mémoire contenues dans ledit réseau de cellules de mémoire, des première et seconde bornes de tension (TVCC, TGND) pour recevoir respectivement des première et seconde tensions, des premier et second câblages (VS, GS) pour connecter respectivement ledit amplificateur de détection auxdites première et seconde bornes de tension, des troisième et quatrième câblages (VY, GY) pour connecter respectivement ledit circuit de sélection de colonne auxdites première et seconde bornes de tension, des cinquième et sixième câblages (VX, GX) pour connecter respectivement ledit circuit de sélection de rangée auxdites première et seconde bornes de tension et des septième et huitième câblages (VB, GB) pour connecter respectivement ledit circuit de sélection de bloc de cellules de mémoire auxdites première et seconde bornes de tension,

dans lequel ledit dispositif de mémoire comprend en outre un élément d'impédance (RX) inséré entre ledit circuit de sélection de rangée (3-1) et ledit cinquième câblage (VX) pour appliquer par son intermédiaire ladite première tension de ladite première borne de tension audit circuit de sélection de rangée.

FIG.1     prior Art

FIG.2

FIG.3A

FIG.3B

FIG.4 prior Art

FIG.8

FIG.5    prior Art

FIG.6A

FIG.6B

FIG.6C

FIG.6D

FIG.7

FIG.9

FIG.10

FIG.11

FIG.12

FIG.13

FIG.14

FIG.15

FIG.16

FIG.17

FIG.18

FIG. 19